# EUROPEAN PATENT APPLICATION

(11) **EP 2 432 004 A1**
(43) Date of publication of application: **21.03.2012**
(21) Application number: 10774829.5
(22) Date of filing: 27.04.2010
(51) Int. Cl.: H01L 21/337, H01L 21/02, H01L 21/20, H01L 29/808

(54) **SEMICONDUCTOR DEVICE**

(30) Priority: 11.05.2009 JP 2009114737; 24.09.2009 JP 2009219065; 01.10.2009 JP 2009229764; 29.10.2009 JP 2009248621; 05.02.2010 JP 2010024370
(71) Applicant: Sumitomo Electric Industries, Ltd., Osaka-shi, Osaka 541-0041 (JP)
(72) Inventor: FUJIKAWA, Kazuhiro, Osaka-shi Osaka 554-0024 (JP); HARADA, Shin, Osaka-shi Osaka 554-0024 (JP); NISHIGUCHI, Taro, Itami-shi Hyogo 664-0016 (JP); SASAKI, Makoto, Itami-shi Hyogo 664-0016 (JP); NAMIKAWA, Yasuo, Itami-shi Hyogo 664-0016 (JP); FUJIWARA, Shinsuke, Itami-shi Hyogo 664-0016 (JP)
(74) Representative: Grünecker, Kinkeldey, Stockmair & Schwanhäusser
(86) International application number: PCT/JP2010/057443
(87) International publication number: WO 2010/131571

(57) **Abstract**

A JFET (100), which is a semiconductor device allowing for reduced manufacturing cost, includes: a silicon carbide substrate (1); an active layer (8) made of single-crystal silicon carbide and disposed on one main surface of the silicon carbide substrate (1); a source electrode (92) disposed on the active layer (8); and a drain electrode (93) formed on the active layer (8) and separated from the source electrode (92). The silicon carbide substrate (1) includes: a base layer (10) made of single-crystal silicon carbide, and a SiC layer (20) made of single-crystal silicon carbide and disposed on the base layer (10). The SiC layer (20) has a defect density smaller than that of the base layer (10).

## Description

### TECHNICAL FIELD

The present invention relates to a semiconductor device, more particularly, a semiconductor device allowing for reduced manufacturing cost.

### BACKGROUND ART

In recent years, in order to achieve high breakdown voltage, low loss, and utilization of semiconductor devices under a high temperature environment, silicon carbide (SiC) has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have a high breakdown voltage, reduced on-resistance, and the like. Further, the semiconductor device thus adopting silicon carbide as its material has characteristics less deteriorated even under a high temperature environment than those of a semiconductor device adopting silicon as its material, advantageously.

Under such circumstances, various studies have been conducted on methods for manufacturing silicon carbide crystals and silicon carbide substrates used for manufacturing of semiconductor devices, and various ideas have been proposed (for example, see M. Nakabayashi, et al., "Growth of Crack-free 100mm-diameter 4H-SiC Crystals with Low Micropipe Densities, Mater. Sci. Forum, vols. 600-603, 2009, p.3-6 (Non-Patent Literature 1)).

### CITATION LIST

### NON PATENT LITERATURE

NPL 1: M. Nakabayashi, et al., "Growth of Crack-free 100mm-diameter 4H-SiC Crystals with Low Micropipe Densities, Mater. Sci. Forum, vols. 600-603, 2009, p.3-6

### SUMMARY OF INVENTION

### TECHNICAL PROBLEM

However, silicon carbide does not have a liquid phase at an atmospheric pressure. In addition, crystal growth temperature thereof is 2000°C or greater, which is very high. This makes it difficult to control and stabilize growth conditions. Accordingly, it is difficult for a silicon carbide single-crystal to have a large diameter while maintaining its quality to be high. Hence, it is not easy to obtain a high-quality silicon carbide substrate having a large diameter. This difficulty in fabricating such a silicon carbide substrate having a large diameter results in not only increased manufacturing cost of the silicon carbide substrate but also fewer semiconductor devices produced for one batch using the silicon carbide substrate. Accordingly, manufacturing cost of the semiconductor devices is increased, disadvantageously. It is considered that the manufacturing cost of the semiconductor devices can be reduced by effectively utilizing a silicon carbide single-crystal, which is high in manufacturing cost, as a substrate.

In view of this, to address the above-described problem, the present invention has its object to provide a semiconductor device allowing for reduced manufacturing cost.

### SOLUTION TO PROBLEM

A semiconductor device according to the present invention includes: a silicon carbide substrate; an active layer made of single-crystal silicon carbide and disposed on one main surface of the silicon carbide substrate; a first electrode disposed on the active layer; and a second electrode formed on the active layer and separated from the first electrode. The silicon carbide substrate includes a base layer made of single-crystal silicon carbide, and a SiC layer made of single-crystal silicon carbide and disposed on the base layer. The SiC layer has a defect density smaller than that of the base layer.

As described above, it is difficult for a high-quality silicon carbide single-crystal to have a large diameter. Meanwhile, for efficient manufacturing in a process of manufacturing a semiconductor device using a silicon carbide substrate, a substrate provided with predetermined uniform shape and size is required. Hence, even when a high-quality silicon carbide single-crystal (for example, silicon carbide single-crystal having a small defect density) is obtained, a region that cannot be processed into such a predetermined shape and the like by cutting, etc., may not be effectively used.

To address this, the silicon carbide substrate constituting the semiconductor device of the present invention includes the base layer made of single-crystal silicon carbide, and the SiC layer made of single-crystal silicon carbide and formed on the base layer, wherein the SiC layer has a defect density smaller than that of the base layer. Thus, the base substrate formed of low-quality silicon carbide crystal having a large defect density is processed to have the predetermined shape and size to obtain a base layer. On such a base layer, a high-quality silicon carbide single-crystal not shaped into the predetermined shape and the like is disposed as a SiC layer. The silicon carbide substrate thus manufactured have the predetermined uniform shape and size, thus attaining effective manufacturing of semiconductor devices. Further, the silicon carbide substrate thus manufactured utilizes such a high-quality SiC layer to manufacture a semiconductor device, thereby effectively utilizing silicon carbide single-crystal. As a result, according the semiconductor device of the present invention, there can be provided a semiconductor device allowing for reduced manufacturing cost.

Here, the base layer and the SiC layer are connected to each other, for example. On this occasion, the base layer and the SiC layer may be directly connected to each other, or may be connected to each other via an intermediate layer. Further, the term "defect" in the present application includes micro pipe, dislocation, stacking fault, and point defect.

Preferably in the semiconductor device, the SiC layer has a micro pipe density smaller than that of the base layer.

Further, preferably in the semiconductor device, the SiC layer has a threading screw dislocation density smaller than that of the base layer.

Further, preferably in the semiconductor device, the SiC layer has a threading edge dislocation density smaller than that of the base layer.

Further, preferably in the semiconductor device, the SiC layer has a basal plane dislocation density smaller than that of the base layer.

Further, preferably in the semiconductor device, the SiC layer has a mixed dislocation density smaller than that of the base layer.

Further, preferably in the semiconductor device, the SiC layer has a stacking fault density smaller than that of the base layer.

Further, preferably in the semiconductor device, the SiC layer has a point defect density smaller than that of the base layer.

As compared with the base layer, the SiC layer is adapted to have the reduced defect densities such as the micro pipe density, the threading screw dislocation density, the threading edge dislocation density, the basal plane dislocation density, the mixed dislocation density, the stacking fault density, and the point defect density. Such a SiC layer allows a high-quality active layer to be formed on the SiC layer. The active layer can be formed by, for example, combining epitaxial growth and ion implantation of an impurity. Here, the term "impurity" refers to an impurity to be introduced to produce a majority carrier in the silicon carbide substrate.

Preferably in the semiconductor device, a half width of X-ray rocking curve of the SiC layer is smaller than that of the base layer. As such, the SiC layer having such a smaller half width of the X-ray rocking curve, i.e., higher crystallinity than that of the base layer is provided on the base layer, thereby allowing a high-quality active layer to be formed on the SiC layer.

In the semiconductor device, the base layer may have a resistivity of 1 × 10⁵ Ω· cm or greater. This increases resistance value of the base layer, thereby obtaining a lateral type semiconductor device (lateral type device) suitable for handling high frequency.

In the semiconductor device, a plurality of the SiC layers may be stacked. In this way, there can be obtained a semiconductor device including the plurality of SiC layers corresponding to intended functions.

In the semiconductor device, the SiC layer may have a main surface opposite to the base layer and having an off angle of not less than 85° and not more than 95° relative to a {0001} plane. Accordingly, breakdown voltage can be improved in the case where the semiconductor device of the present invention is a lateral type power device such as a lateral type FET (Field Effect Transistor).

In the semiconductor device, the main surface of the SiC layer opposite to the base layer may correspond to a {11-20} plane. Further, in the semiconductor device, the main surface of the SiC layer opposite to the base layer may correspond to a {1-100} plane.

Each of the {11-20} plane and the {1-100} plane is a representative crystal plane having an off angle of not less than 85° and not more than 95° relative to the {0001} plane. Hence, the main surface of the SiC layer opposite to the base layer is thus adapted to correspond to the {11-20} plane or {1-100} plane, thereby facilitating formation of an active layer having good crystallinity on the SiC layer. It should be noted that the expression "the main surface opposite to the base layer corresponds to the {11-20} plane or the {1-100} plane" is intended to mean that the main surface does not need to strictly correspond to the {11-20} plane or the {1-100} plane, and may correspond to substantially the {11-20} plane or the {1-100} plane. The expression "the main surface corresponds to substantially the {11-20} or the {1-100} plane" is intended to encompass a case where the plane orientation of the main surface is included in a range of off angle such that the plane orientation can be substantially regarded as {11-20} or {1-100} in consideration of processing accuracy of the substrate. In this case, the range of off angle is, for example, a range of off angle of ±2° relative to the {11-20} plane or the {1-100} plane.

In the semiconductor device, the first electrode and the second electrode are arranged in a <0001> direction of the single-crystal silicon carbide constituting the SiC layer. This leads to improved breakdown voltage in the lateral type power device such as a lateral type FET.

The semiconductor device can further include a third electrode formed on the active layer between the first electrode and the second electrode and separated from the first electrode and the second electrode, wherein the first electrode is a source electrode, the second electrode is a drain electrode, and the third electrode is a gate electrode. In this way, the above-described semiconductor device can be a lateral type FET.

In the semiconductor device, the active layer may include: a buffer layer disposed on the silicon carbide substrate and having a first conductivity type, and a channel layer disposed on the buffer layer and having a second conductivity type. Accordingly, the semiconductor device can be a lateral type JFET (Junction Field Effect Transistor) or a lateral type MESFET (Metal Semiconductor Field Effect Transistor).

In the semiconductor device, the active layer may further include: a source region having the second conductivity type and extending from its location in contact with the first electrode to come into the channel layer, a drain region having the second conductivity type and extending from its location in contact with the second electrode to come into the channel layer, and a gate region having the first conductivity type and extending from its location in contact with the third electrode to come into the channel layer. In this way, the semiconductor device can be a lateral type JFET.

In the semiconductor device, the active layer may further include a resurf layer having the first conductivity type and disposed on the channel layer. Accordingly, the semiconductor device can be a lateral type JFET having a reduced surface field (RESURF) structure, thereby achieving both high breakdown voltage and low loss.

In the semiconductor device, the silicon carbide substrate may further include an intermediate layer disposed between the base layer and the SiC layer, and the intermediate layer may connect the base layer and the SiC layer to each other.

Thus, by employing the structure in which the base layer and the SiC layer are connected to each other by the intermediate layer, there can be readily obtained the silicon carbide substrate in which the SiC layer having a defect density smaller than that of the base layer is provided on the base layer. As a material constituting the intermediate layer, a conductor or a semiconductor may be employed.

In the semiconductor device, the intermediate layer may be made of a metal. In the semiconductor device, the intermediate layer may be made of carbon. In the semiconductor device, the intermediate layer may be made of amorphous silicon carbide. By employing metal, carbon, amorphous silicon carbide, or the like as a material constituting the intermediate layer, the base layer and the SiC layer can be readily connected to each other.

### ADVANTAGEOUS EFFECTS OF INVENTION

As apparent from the description above, according to the semiconductor device of the present invention, there can be provided a semiconductor device allowing for reduced manufacturing cost.

### BRIEF DESCRIPTION OF DRAWINGS

Fig. 1 is a schematic cross sectional view showing a structure of a RESURF-JFET.
Fig. 2 is a schematic cross sectional view showing a structure of a silicon carbide substrate.
Fig. 3 is a schematic cross sectional view showing a variation of the structure of the silicon carbide substrate.
Fig. 4 is a schematic planar view showing the structure of the RESURF-JFET.
Fig. 5 is a flowchart schematically showing a method for manufacturing the RESURF-JFET.
Fig. 6 is a schematic cross sectional view for illustrating the method for manufacturing the RESURF-JFET.
Fig. 7 is a schematic cross sectional view for illustrating the method for manufacturing the RESURF-JFET.
Fig. 8 is a schematic cross sectional view for illustrating the method for manufacturing the RESURF-JFET.
Fig. 9 is a schematic cross sectional view for illustrating the method for manufacturing the RESURF-JFET.
Fig. 10 is a schematic cross sectional view for illustrating the method for manufacturing the RESURF-JFET.
Fig. 11 is a flowchart schematically showing a method for manufacturing the silicon carbide substrate.
Fig. 12 is a schematic cross sectional view showing a structure of a lateral type JFET in a second embodiment.
Fig. 13 is a flowchart schematically showing a method for manufacturing a silicon carbide substrate in a third embodiment.
Fig. 14 is a schematic cross sectional view for illustrating the method for manufacturing the silicon carbide substrate in the third embodiment.
Fig. 15 is a schematic cross sectional view for illustrating the method for manufacturing the silicon carbide substrate in the third embodiment.
Fig. 16 is a schematic cross sectional view for illustrating the method for manufacturing the silicon carbide substrate in the third embodiment.
Fig. 17 is a schematic cross sectional view showing a structure of a silicon carbide substrate in a fourth embodiment.
Fig. 18 is a schematic cross sectional view showing a structure of a silicon carbide substrate in a fifth embodiment.
Fig. 19 is a flowchart schematically showing a method for manufacturing the silicon carbide substrate in the fifth embodiment.
Fig. 20 is a schematic cross sectional view showing a structure of a silicon carbide substrate in a sixth embodiment.
Fig. 21 is a flowchart schematically showing a method for manufacturing the silicon carbide substrate in the sixth embodiment.
Fig. 22 is a schematic cross sectional view showing a structure of a silicon carbide substrate in a seventh embodiment.
Fig. 23 is a flowchart schematically showing a method for manufacturing the silicon carbide substrate in the seventh embodiment.
Fig. 24 is a schematic cross sectional view for illustrating the method for manufacturing the silicon carbide substrate in the seventh embodiment.

### DESCRIPTION OF EMBODIMENTS

The following describes embodiments of the present invention with reference to figures. It should be noted that in the below-mentioned figures, the same or corresponding portions are given the same reference characters and are not described repeatedly.

### (First Embodiment)

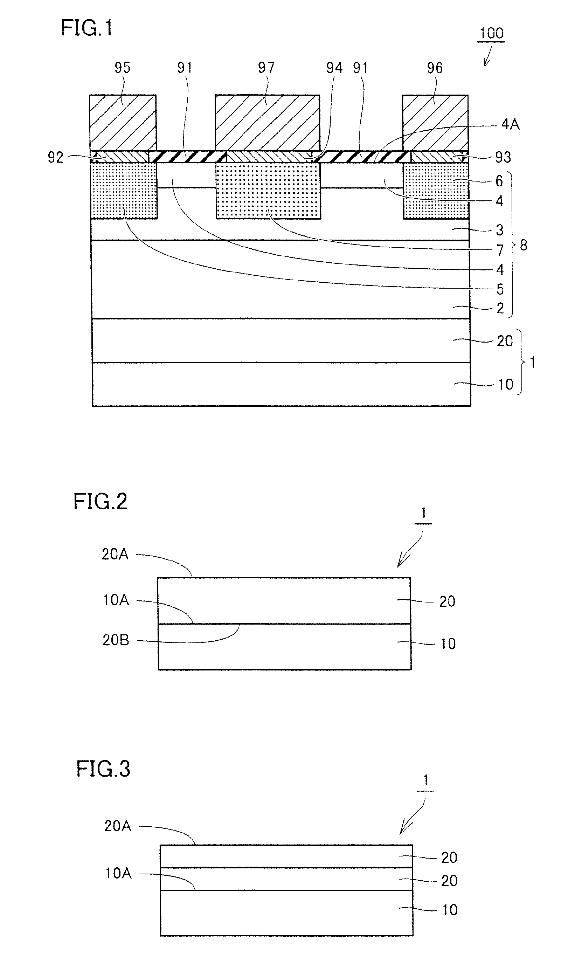

First, a first embodiment, i.e., one embodiment of the present invention will be described. Referring to Fig. 1, a JFET 100, which is a junction field effect transistor (JFET) in the present embodiment, includes: a silicon carbide substrate 1 having n type conductivity; a first p type layer 2 formed on silicon carbide substrate 1; an n type layer 3 formed on first p type layer 2; and a second p type layer 4 formed on n type layer 3. Here, each p type layer and the n type layer are layers made of silicon carbide and having p type conductivity (first conductivity type) and n type conductivity (second conductivity type), respectively.

Second p type layer 4 and n type layer 3 have a first n type region 5 and a second n type region 6, each of which contains an impurity having n type conductivity (n type impurity) at a concentration higher than that in n type layer 3. Between first n type region 5 and second n type region 6, a p type region 7 is formed which contains an impurity having p type conductivity (p type impurity) at a concentration higher than those in first p type layer 2 and second p type layer 4. Namely, first n type region 5, p type region 7, and second n type region 6 are formed to come into n type layer 3 through second p type layer 4. Further, each of first n type region 5, p type region 7, and second n type region 6 has a bottom portion spaced away from the upper surface of first p type layer 2 (boundary between first p type layer 2 and n type layer 3).

Here, each of first n type region 5, p type region 7, and second n type region 6 is an ion implantation region formed by implanting ions therein. Further, first p type layer 2, n type layer 3, second p type layer 4, first n type region 5, second n type region 6, and p type region 7 constitute an active layer 8.

Further, a source electrode 92, a gate electrode 94, and a drain electrode 93 are formed in contact with the upper surfaces of first n type region 5, p type region 7, and second n type region 6, respectively. Source electrode 92, gate electrode 94, and drain electrode 93 are made of a material allowing for ohmic contact with first n type region 5, p type region 7, and second n type region 6. An exemplary material therefor is NiSi (nickel silicide).

An oxide film 91 is formed between adjacent ones of source electrode 92, gate electrode 94, and drain electrode 93. More specifically, on an upper surface 4A of second p type layer 4, oxide film 91, which serves as an insulating film, is formed to cover the entire region other than the regions in which source electrode 92, gate electrode 94, and drain electrode 93 are formed. In this way, adjacent electrodes are insulated from each other.

Further, a source wire 95, a gate wire 97, and a drain wire 96 are formed in contact with the upper surfaces of source electrode 92, gate electrode 94, and drain electrode 93 so as to be electrically connected thereto, respectively. Each of source wire 95, gate wire 97, and drain wire 96 is made of a conductor such as aluminum (Al).

Specifically, JFET 100 serving as the semiconductor device of the present embodiment includes: silicon carbide substrate 1; active layer 8 made of single-crystal silicon carbide and provided on one main surface of silicon carbide substrate 1; source electrode 92 provided on active layer 8 and serving as a first electrode; drain electrode 93 formed on active layer 8, separated from source electrode 92, and serving as a second electrode; and gate electrode 94 formed on active layer 8 between source electrode 92 and drain electrode 93, separated from source electrode 92 and drain electrode 93, and serving as a third electrode.

Further, active layer 8 includes: first p type layer 2 provided on silicon carbide substrate 1 and serving as a buffer layer of first conductivity type (p type); n type layer 3 provided on first p type layer 2 and serving as a channel layer of second conductivity type (n type); and second p type layer 4 provided on n type layer 3 and serving as a resurf layer of first conductivity type (p type). Active layer 8 further includes: first n type region 5 serving as a source region extending from its location in contact with source electrode 92 to come into n type layer 3; second n type region 6 serving as a drain region extending from its location in contact with drain electrode 93 to come into n type layer 3; and p type region 7 serving as a gate region extending from its location in contact with gate electrode 94 to come into n type layer 3.

The following describes operations of JFET 100, assuming that JFET 100 is of normally off type, for example. Referring to Fig. 1, in n type layer 3, a region sandwiched between second n type region 6 and p type region 7, a region sandwiched between the foregoing sandwiched region and first p type layer 2, and a region sandwiched between p type region 7 and first p type layer 2 are not depleted when gate electrode 94 has a potential of 0 V. Hence, first n type region 5 and second n type region 6 are connected to each other via n type layer 3. Accordingly, when an electric field is applied between source electrode 92 and drain electrode 93, electrons are moved between first n type region 5 and second n type region 6, whereby a current flows between source electrode 92 and drain electrode 93 (ON state).

Meanwhile, when applying negative voltage to gate electrode 94, depletion develops in the drift region in which electrons are to move, thereby electrically disconnecting first n type region 5 and second n type region 6 from each other. Accordingly, the electrons cannot be moved between first n type region 5 and second n type region 6, with the result that no current flows (OFF state). Here, JFET 100 in the present embodiment is a RESURF type JFET having second p type layer 4 (resurf layer) formed on and in contact with n type layer 3. Accordingly, in the OFF state, the depletion layer in the drift region extends in the upward/downward direction (in the thickness direction) from an interface between n type layer 3 and second p type layer 4. Accordingly, electric field distribution in the drift region becomes uniform to reduce electric field concentrates in the vicinity of gate electrode 94, thereby improving breakdown voltage.

Referring to Fig. 1 and Fig. 2, in the present embodiment, silicon carbide substrate 1 constituting JFET 100 includes a base layer 10 made of single-crystal silicon carbide, and a SiC layer 20 made of single-crystal silicon carbide and arranged on base layer 10. SiC layer 20 has a defect density smaller than that of base layer 10. Thus, a base substrate formed of low-quality silicon carbide crystal having a large defect density is processed to have appropriate shape and size, thereby obtaining base layer 10. On such a base layer 10, a high-quality silicon carbide single-crystal not shaped into the desired shape and the like is disposed as SiC layer 20. Silicon carbide substrate 1 obtained in this way is uniformly shaped and sized appropriately, thereby achieving efficient manufacturing of semiconductor devices (JFETs 100). Further, silicon carbide substrate 1 obtained in this way utilizes such a high-quality SiC layer 20 to manufacture a semiconductor device (JFET 100), thereby effectively utilizing silicon carbide single-crystal. Accordingly, JFET 100 of the present invention is a semiconductor device manufactured with reduced cost. It should be noted that there is a boundary between base layer 10 and SiC layer 20 and defect density may be discontinuous at this boundary.

Here, in JFET 100, SiC layer 20 preferably has a micro pipe density smaller than that of base layer 10. Further, in JFET 100, SiC layer 20 preferably has a threading screw dislocation density smaller than that of base layer 10. Further, in JFET 100, SiC layer 20 preferably has a threading edge dislocation density smaller than that of base layer 10. Further, in JFET 100, SiC layer 20 preferably has a basal plane dislocation density smaller than that of base layer 10. Further, in JFET 100, SiC layer 20 preferably has a mixed dislocation density smaller than that of base layer 10. Further, in JFET 100, SiC layer 20 preferably has a stacking fault density smaller than that of base layer 10. Further, in JFET 100, SiC layer 20 preferably has a point defect density smaller than that of base layer 10.

Thus, as compared with base layer 10, SiC layer 20 has the reduced defect densities such as the micro pipe density, the threading screw dislocation density, the threading edge dislocation density, the basal plane dislocation density, the mixed dislocation density, the stacking fault density, and the point defect density. Such a SiC layer 20 allows a high-quality active layer 8 to be formed on SiC layer 20.

Further, in JFET 100, the half width of X-ray rocking curve of SiC layer 20 is preferably smaller than that of base layer 10. As such, SiC layer 20 having such a smaller half width of the X-ray rocking curve, i.e., having higher crystallinity than that of base layer 10 is provided on base layer 10, thereby allowing a high-quality active layer 8 to be formed on SiC layer 20.

Further, in JFET 100, base layer 10 has a resistivity of 1 × 10⁵ Ω·cm or greater. This increases resistance value of base layer 10, thereby obtaining JFET 100 suitable for handling high frequency.

Further, referring to Fig. 3, in JFET 100 in the present embodiment, a plurality of SiC layers 20 constituting silicon carbide substrate 1 (two SiC layers 20 in Fig. 3) may be stacked. Accordingly, for example, SiC layers 20 different in impurity concentration can be stacked.

Further, in JFET 100 in the present embodiment, main surface 20A of SiC layer 20 opposite to base layer 10 preferably has an off angle of not less than 85° and no more than 95° relative to the {0001} plane. In this way, when first p type layer 2, n type layer 3, and second p type layer 4 are formed on such a main surface 20A thereof by means of epitaxial growth, breakdown voltage of JFET 100 can be improved. More specifically, main surface 20A may correspond to substantially {11-20} or substantially {1-100}.

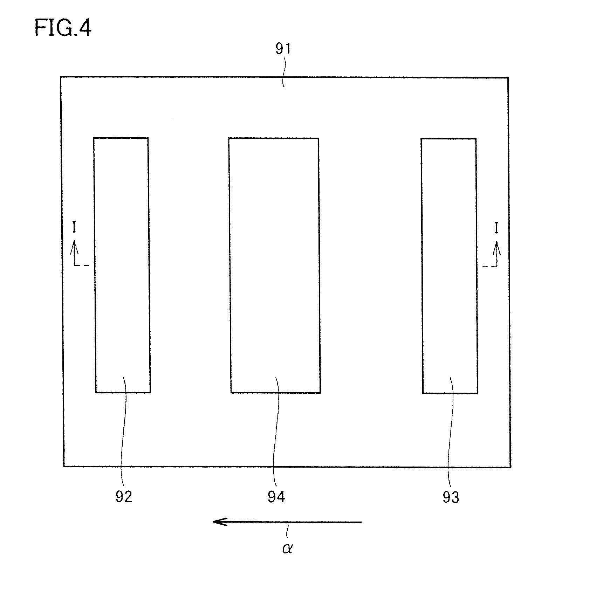

Further, referring to Fig. 4, in JFET 100, source electrode 92 and drain electrode 93 may be arranged in the <0001> direction of each of single-crystal silicon carbide constituting SiC layer 20 and single-crystal silicon carbide constituting first p type layer 2, n type layer 3, and second p type layer 4, each of which has been formed on SiC layer 20 by means of epitaxial growth. More specifically, source electrode 92, gate electrode 94, and drain electrode 93 may be arranged in a direction along an arrow α, which represents the <0001> direction. This achieves improved breakdown voltage of JFET 100. It should be noted that Fig. 1 corresponds to a cross section taken along a line I-I in Fig. 4.

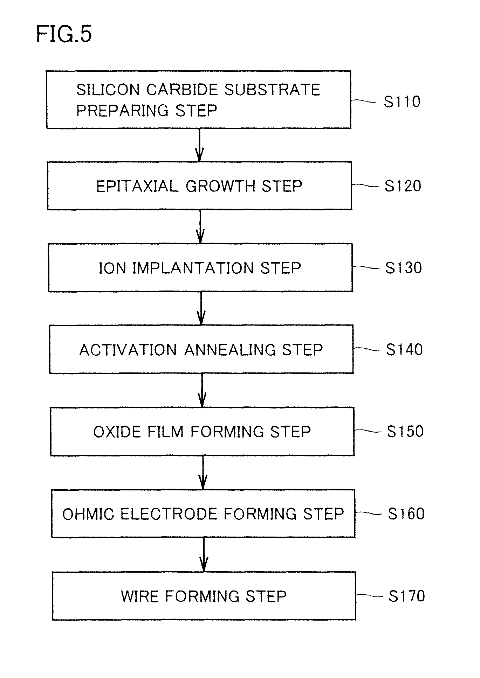

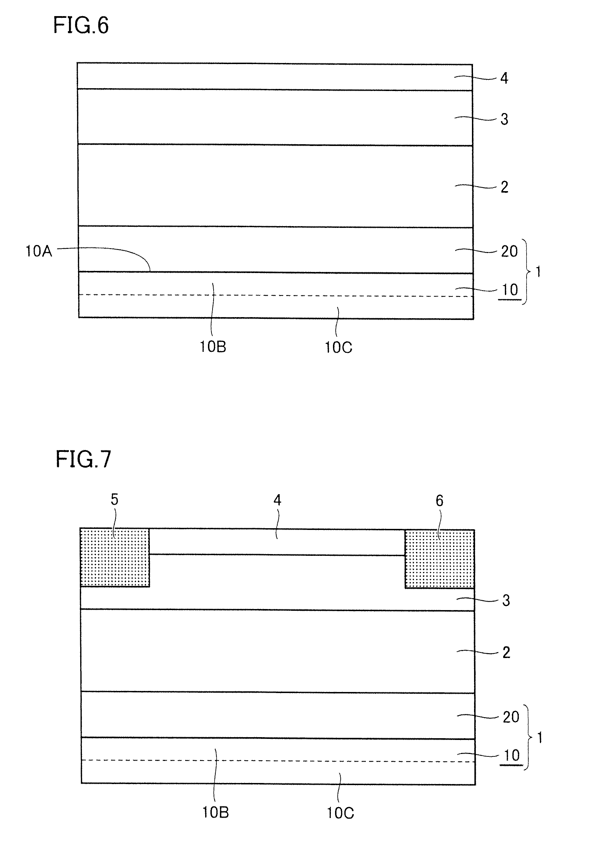

The following describes one exemplary method for manufacturing JFET 100 in the first embodiment, with reference to Fig. 5-Fig. 10. Referring to Fig. 5, in the method for manufacturing JFET 100 in the present embodiment, a silicon carbide substrate preparing step is first performed as a step (S110). In this step (S110), referring to Fig. 6, silicon carbide substrate 1 is manufactured which includes base layer 10 made of single-crystal silicon carbide, and SiC layer 20 made of single-crystal silicon carbide and provided on base layer 10. SiC layer 20 has a defect density smaller than that of base layer 10. In silicon carbide substrate 1 manufactured in this step (S110), the following base layer 10 may be employed instead of base layer 10 entirely formed of single-crystal silicon carbide. That is, base layer 10 employed includes: a single-crystal layer 10B made of single-crystal silicon carbide and including main surface 10A facing SiC layer 20, and the other region 10C made of polycrystal silicon carbide, amorphous silicon carbide, or a silicon carbide sintered compact. A method for manufacturing silicon carbide substrate 1 will be described below.

Next, as a step (S120), an epitaxial growth step is performed. In this step (S120), referring to Fig. 6, first p type layer 2, n type layer 3, and second p type layer 4 each made of silicon carbide are sequentially formed on one main surface of silicon carbide substrate 1 by means of epitaxial growth. More specifically, for example, first p type layer 2 is formed to contain p type impurity at a density of 1.0 × 10¹⁶ cm⁻³ and have a thickness of 10 µm. N type layer 3 is formed to contain n type impurity at a density of 2.0 × 10¹⁷ cm⁻³ and have a thickness of 0.4 µm. Second p type layer 4 is formed to contain p type impurity at a density of 2.0 × 10¹⁷ cm⁻³ and have a thickness of 0.25 µm.

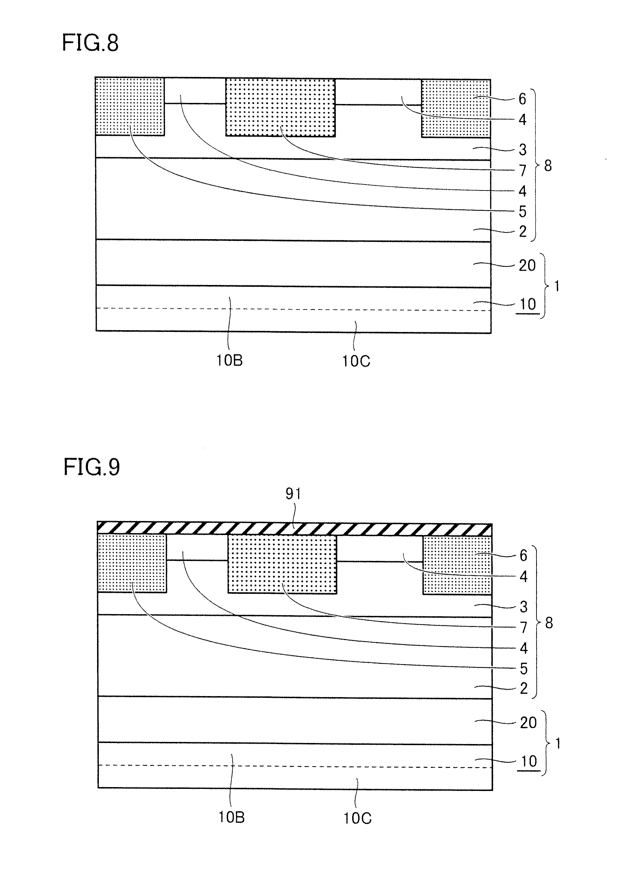

Next, as a step (S130), an ion implantation step is performed. In this step (S130), referring to Fig. 6 and Fig. 7, ion implantation is first performed to form the source region and the drain region. Specifically, for example, P (phosphorus) ions are implanted to a depth of 0.5 µm at a density of 1.0 x10¹⁹ cm⁻³, thereby forming first n type region 5 and second n type region 6. Thereafter, as shown in Fig. 8, ion implantation is performed to form the gate region. Specifically, A1 (aluminum) ions are implanted to a depth of 0.4 µm at a density of 2.0 x10¹⁸ cm⁻³, thereby forming p type region 7. The ions can be implanted using a mask layer formed on second p type layer 4, made of silicon dioxide (SiO₂), and having openings at desired regions to be subjected to the ion implantation, for example.

Next, as a step (S140), an activation annealing step is performed. In this step (S140), for example, heat treatment is performed by heating to 1700°C in an inert gas atmosphere such as argon for 30 minutes. Accordingly, the impurities implanted in the above-described step (S130) are activated.

Next, as a step (S150), an oxide film forming step is performed. In this step (S150), referring to Fig. 8 and Fig. 9, for example, heat treatment is performed by heating to 1300°C in an oxygen atmosphere for 60 minutes, thereby forming oxide film 91 (field oxide film).

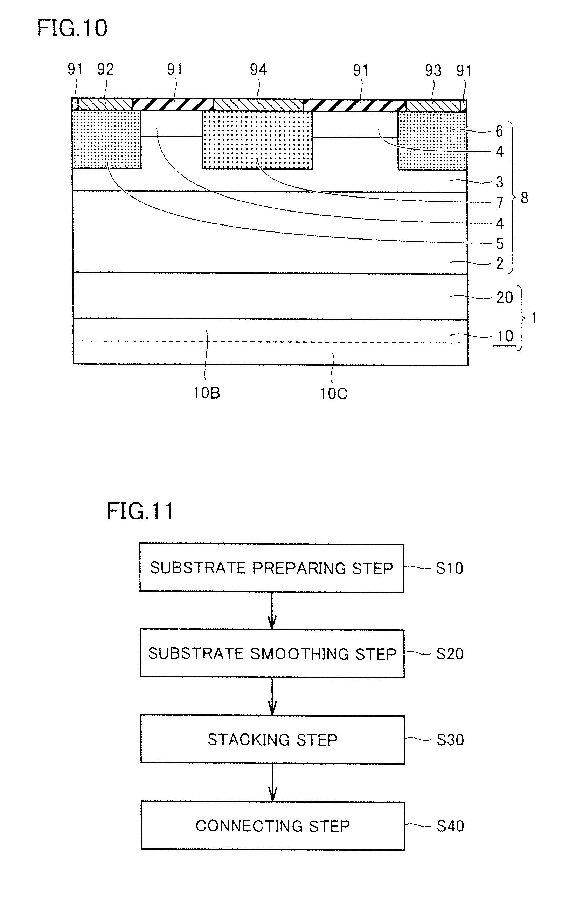

Next, as a step (S160), an ohmic electrode forming step is performed. In this step (S160), the source electrode, the gate electrode, and the drain electrode are formed. Specifically, referring to Fig. 9 and Fig. 10, first, oxide film 91 formed in step (S150) is provided with openings at its regions respectively corresponding to first n type region 5, second n type region 6, and p type region 7. Thereafter, Ni (nickel) is deposited in contact with first n type region 5, second n type region 6, and p type region 7, each of which is exposed from the openings, for example. Next, for example, in an Ar atmosphere, heat treatment is performed by heating to 950°C for two minutes, thereby siliciding part of the deposited Ni (respective regions in contact with first n type region 5, second n type region 6, and p type region 7) or entire part thereof. In this way, source electrode 92, drain electrode 93, and gate electrode 94 are formed which are capable of ohmic contact with first n type region 5, second n type region 6, and p type region 7 respectively.

Next, as a step (S170), a wire forming step is performed. In this step (S170), referring to Fig. 10 and Fig. 1, the wires are formed on and in contact with source electrode 92, drain electrode 93, and gate electrode 94 formed in step (S160). Specifically, source wire 95, drain wire 96, and gate wire 97 are formed by, for example, depositing Al on source electrode 92, drain electrode 93, and gate electrode 94. With the above-described procedure, JFET 100 in the present embodiment is completed.

In the case where there is adopted in step (S110) a base layer 10 that includes a single-crystal layer 10B made of single-crystal silicon carbide and including main surface 10A facing SiC layer 20 and includes the other region 10C made of polycrystal silicon carbide, amorphous silicon carbide, or silicon carbide sintered compact, a step of removing the other region 10C may be performed. In this way, JFET 1 shown in Fig. 1 can be obtained. Meanwhile, the step of removing region 10C described above may not be performed. In this case, a non single-crystal layer (corresponding to region 10C described above) made of polycrystal silicon carbide, amorphous silicon carbide, or silicon carbide sintered compact is formed on the main surface of base layer 10 opposite to SiC layer 20 in JFET 1 shown in Fig. 1 (i.e., as a lower layer in base layer 10 in Fig. 1). In JFET 100, which is a lateral type device, the non single-crystal layer has small influence over characteristics of JFET 100. Hence, when such a manufacturing process is employed, manufacturing cost of JFET 100 can be reduced while preventing deterioration of the characteristics thereof.

The following describes the silicon carbide substrate preparing step performed as step (S1 10) described above. Referring to Fig. 11, in manufacturing the silicon carbide substrate in the present embodiment, first, as step (S10), the substrate preparing step is performed. In this step (S10), referring to Fig. 2 and Fig. 3, base substrate 10 formed of single-crystal silicon carbide and a SiC substrate 20 formed of single-crystal silicon carbide are prepared.

SiC substrate 20 has main surface 20A, which will be the main surface of the silicon carbide substrate that will be obtained by this manufacturing method. Hence, on this occasion, the plane orientation of main surface 20A of SiC substrate 20 is selected in accordance with desired plane orientation of main surface 20A. Here, for example, a SiC substrate 20 having a main surface corresponding to the {11-20} plane or {1-100} plane is prepared.

Next, a substrate smoothing step is performed as a step (S20). Step (S20) is not an essential step, but can be performed when the smoothness of base substrate 10 and/or SiC substrate 20 prepared in step (S10) is insufficient. Specifically, for example, the main surface(s) of base substrate 10 and/or SiC substrate 20 are polished.

Meanwhile, step (S20) may be omitted, i.e., step (S30) may be performed without polishing the main surfaces of base substrate 10 and SiC substrate 20, which are to be brought into contact with each other. This reduces manufacturing cost of silicon carbide substrate 1. Further, for removal of damaged layers located in the vicinity of surfaces formed by slicing upon fabrication of base substrate 10 and SiC substrate 20, a step of removing the damaged layers may be performed by, for example, etching instead of step (S20) or after step (S20), and then step (S30) described below may be performed.

Next, a stacking step is performed as step (S30). In this step (S30), referring to Fig. 2, base substrate 10 and SiC substrate 20 are stacked on each other to bring their main surfaces 10A, 20B into contact with each other, thereby fabricating a stacked substrate. It should be noted that when fabricating a silicon carbide substrate 1 in which a plurality of SiC layers 20 are stacked, a plurality of (here, two) SiC substrates 20 are stacked on base substrate 10 as shown in Fig. 3.

Next, as step (S40), a connecting step is performed. In this step (S40), by heating the stacked substrate to fall within, for example, a range of temperature equal to or greater than the sublimation temperature of silicon carbide, base substrate 10 and SiC substrate 20 are connected to each other. In this way, referring to Fig. 2 and Fig. 3, silicon carbide substrate 1 including base layer 10 and SiC layer 20 is completed. Further, by heating to the temperature equal to or greater than the sublimation temperature, base substrate 10 and SiC substrate 20 can be connected to each other readily even in the case where step (S20) is not performed and step (S30) is performed without polishing the main surfaces of base substrate 10 and SiC substrate 20 which are to be brought into contact with each other. It should be noted that in this step (S40), the stacked substrate may be heated in an atmosphere obtained by reducing pressure of the atmospheric air. This reduces manufacturing cost of silicon carbide substrate 1.

Further, heating temperature for the stacked substrate in step (S40) is preferably not less than 1800°C and not more than 2500°C. If the heating temperature is lower than 1800°C, it takes a long time to connect base substrate 10 and SiC substrate 20, which results in decreased efficiency in manufacturing silicon carbide substrate 1. On the other hand, if the heating temperature exceeds 2500°C, surfaces of base substrate 10 and SiC substrate 20 become rough, which may result in generation of a multiplicity of crystal defects in silicon carbide substrate 1 to be fabricated. In order to improve efficiency in manufacturing while restraining generation of defects in silicon carbide substrate 1, the heating temperature for the stacked substrate in step (S40) is preferably set at not less than 1900°C and not more than 2100°C. Further, in this step (S40), the stacked substrate may be heated under a pressure higher than 10⁻¹ Pa and lower than 10⁴ Pa. This can accomplish the above-described connection using a simple device, and provide an atmosphere for accomplishing the connection for a relatively short time, thereby achieving reduced manufacturing cost of silicon carbide substrate 1. Further, the atmosphere upon the heating in step (S40) may be inert gas atmosphere. In the case where the atmosphere is the inert gas atmosphere, the inert gas atmosphere preferably contains at least one selected from a group consisting of argon, helium, and nitrogen.

Further, in the method for manufacturing JFET 100 in the present embodiment, JFET 100 is manufactured using silicon carbide substrate 1 thus obtained.

### (Second Embodiment)

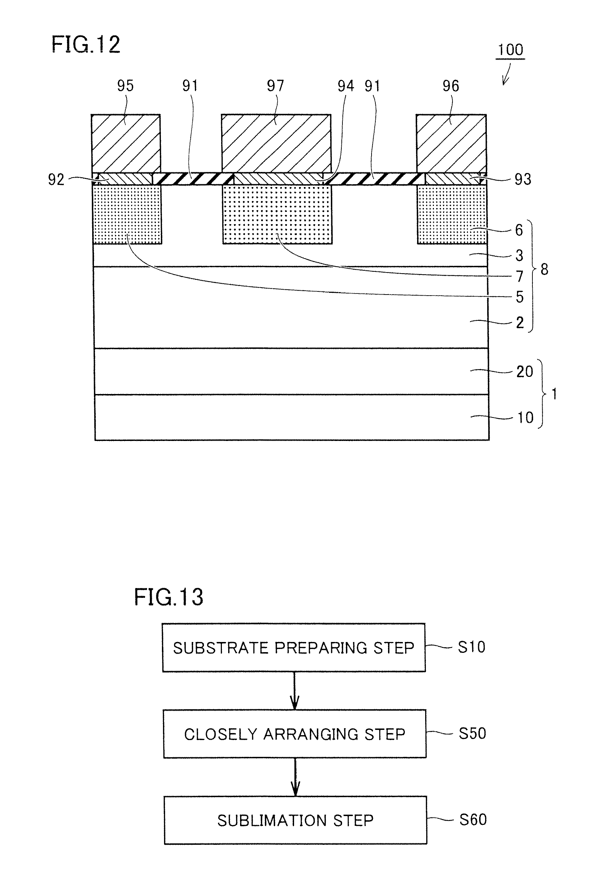

The following describes another embodiment of the present invention, i.e., a second embodiment. Referring to Fig. 12, a JFET 100 serving as a semiconductor device in a second embodiment has the basically the same structure and provides basically the same effect as those of JFET 100 of the first embodiment described with reference to Fig. 1-Fig. 4. However, JFET 100 in the second embodiment is different from that of the first embodiment in that it does not include second p type layer 4 serving as a resurf layer. Specifically, while JFET 100 of the first embodiment is a JFET of RESURF type, JFET 100 in the present embodiment is a general JFET of lateral type, apart from the configuration of silicon carbide substrate 1. Accordingly, JFET 100 in the present embodiment operates in a similar manner to JFET 100 of the first embodiment, except that in the OFF state, a depletion layer extends from p type region 7 serving as the gate region to second n type region 6 serving as the drain region. Further, apart from the omission of the formation of second p type layer 4 in step (S120), JFET 100 in the present embodiment can be manufactured in a manner similar to that in the first embodiment.

### (Third Embodiment)

As a third embodiment, the following describes another method for manufacturing a silicon carbide substrate constituting a semiconductor device in the present invention, with reference to Fig. 13-Fig. 16. A method for manufacturing a silicon carbide substrate in the third embodiment is performed in basically the same manner as in the first embodiment. However, the method for manufacturing the silicon carbide substrate in the third embodiment is different from that of the first embodiment in terms of a process of forming base substrate 10.

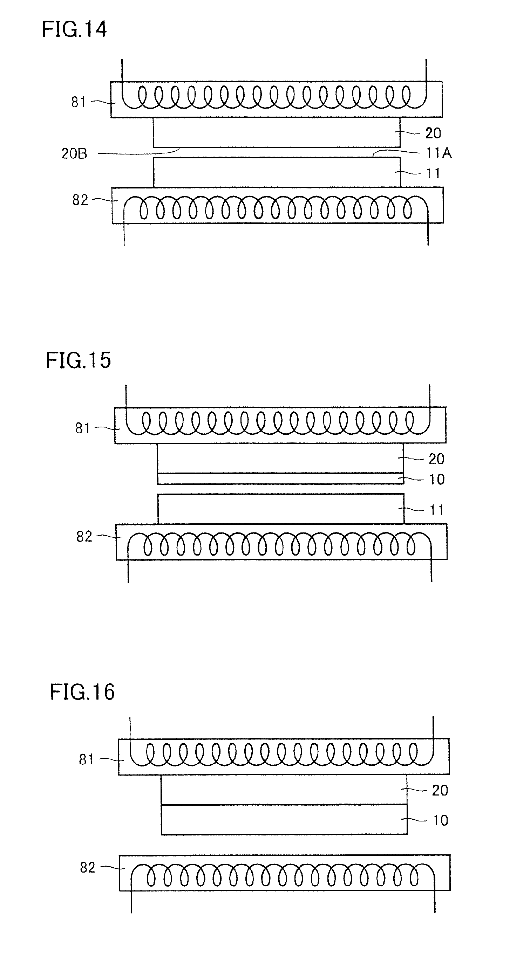

Referring to Fig. 13, the substrate preparing step is first performed as step (S10) in the method for manufacturing the silicon carbide substrate in the third embodiment. In step (S10), referring to Fig. 14, SiC substrate 20 is prepared as with the first embodiment, and a material substrate 11 made of silicon carbide is prepared. Material substrate 11 may be made of single-crystal silicon carbide or polycrystal silicon carbide, or may be a sintered compact of silicon carbide. Further, instead of material substrate 11, material powder made of silicon carbide can be employed.

Next, referring to Fig. 4, a closely arranging step is performed as a step (S50). In this step (S50), referring to Fig. 5, SiC substrate 20 and material substrate 11 are respectively held by a first heater 81 and a second heater 82 disposed face to face with each other. Here, an appropriate value of a space between SiC substrate 20 and material substrate 11 is considered to be associated with a mean free path for a sublimation gas obtained upon heating in a below-described step (S60). Specifically, the average value of the space between SiC substrate 20 and material substrate 11 can be set to be smaller than the mean free path for the sublimation gas obtained upon heating in the below-described step (S60). For example, strictly, a mean free path for atoms and molecules depends on atomic radius and molecule radius at a pressure of 1 Pa and a temperature of 2000°C, but is approximately several cm to several ten cm. Hence, realistically, the space is preferably set at several cm or smaller. More specifically, SiC substrate 20 and material substrate 11 are arranged close to each other such that their main surfaces face each other with a space of not less than 1 µm and not more than 1 cm therebetween. Furthermore, when the average value of the space is 1 cm or smaller, the distribution in film thickness of base layer 10 to be formed in step (S60) described below can be reduced. Furthermore, when the average value of the space is 1 mm or smaller, the distribution in film thickness of base layer 10 to be formed in step (S60) described below can be reduced further. Meanwhile, with the average value of the space being 1 µm or greater, there can be secured a sufficient space for sublimation of silicon carbide. It should be noted that this sublimation gas is a gas formed by sublimation of solid silicon carbide, and includes Si, Si₂C, and SiC₂, for example.

Next, as step (S60), a sublimation step is performed. In this step (S60), SiC substrate 20 is heated to a predetermined substrate temperature by first heater 81. Further, material substrate 11 is heated to a predetermined material temperature by second heater 82. On this occasion, material substrate 11 is heated to reach the material temperature, thereby sublimating SiC from the surface of the material substrate. On the other hand, the substrate temperature is set lower than the material temperature. Specifically, for example, the substrate temperature is set lower than the material temperature by not less than 1°C and not more than 100°C. The substrate temperature is preferably 1800°C or greater and 2500°C or smaller. Accordingly, as shown in Fig. 15, SiC sublimated from material substrate 11 in the form of gas reaches the surface of SiC substrate 20 and is accordingly solidified thereon, thereby forming base layer 10. With this state being maintained, as shown in Fig. 16, all the SiC constituting material substrate 11 is sublimated and is transferred onto the surface of SiC substrate 20. Accordingly, step (S60) is completed, thereby completing silicon carbide substrate 1 shown in Fig. 2.

### (Fourth Embodiment)

The following describes yet another embodiment of the present invention, i.e., a fourth embodiment. A semiconductor device in the fourth embodiment has basically the same structure as that of the first embodiment. However, the semiconductor device of the fourth embodiment is different from that of the first embodiment in terms of its manufacturing method.

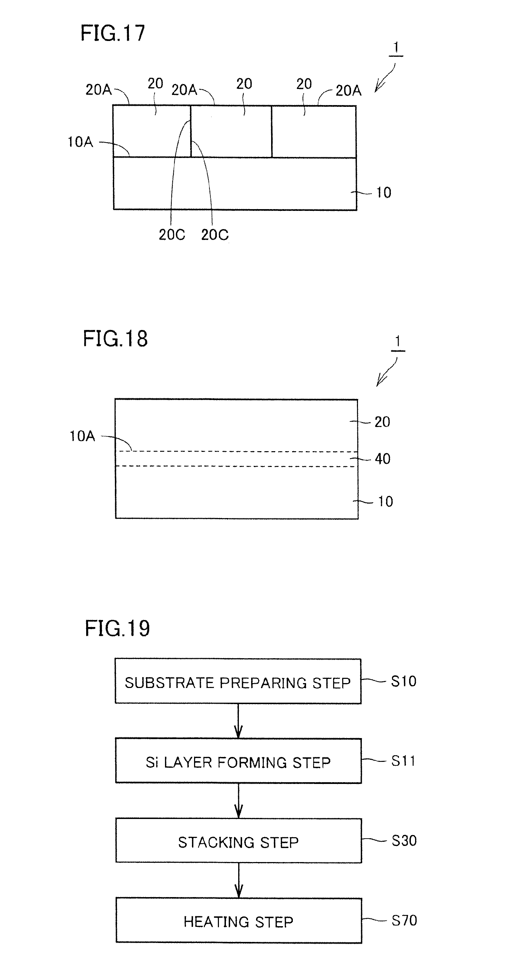

Specifically, a silicon carbide substrate different in structure from that of the first embodiment is prepared in the silicon carbide substrate preparing step performed as step (S1 10) in the method for manufacturing the semiconductor device (for example, JFET) in the fourth embodiment. Referring to Fig. 17, in silicon carbide substrate 1 prepared in the fourth embodiment, a plurality of SiC layers 20 are arranged side by side when viewed in a planar view. In other words, the plurality of SiC layers 20 are arranged along main surface 10A of base layer 10. More specifically, the plurality of SiC layers 20 are arranged in the form of a matrix on base layer 10 such that adjacent SiC layers 20 are in contact with each other. Accordingly, silicon carbide substrate 1 of the present embodiment can be handled as a substrate having high-quality SiC layers 20 and a large diameter. Utilization of such a silicon carbide substrate 1 allows for efficient manufacturing process of semiconductor devices. Further, referring to Fig. 17, each of adjacent SiC layers 20 has an end surface 20C substantially perpendicular to main surface 20A of SiC layer 20. In this way, silicon carbide substrate 1 of the present embodiment can be readily manufactured. Here, for example, when end surface 20C and main surface 20A form an angle of not less than 85° and not more than 95°, it can be determined that end surface 20C and main surface 20A are substantially perpendicular to each other. It should be noted that silicon carbide substrate 1 in the fourth embodiment can be manufactured in a manner similar to that in the first embodiment or the third embodiment as follows. That is, in step (S30) of the first embodiment, a plurality of SiC substrates 20 each having an end surface 20C substantially perpendicular to main surface 20A thereof are arranged side by side when viewed in a planar view (see Fig. 11). Alternatively, in step (S50) of the third embodiment, a plurality of SiC substrates 20 each having an end surface 20C substantially perpendicular to main surface 20A thereof are arranged side by side on and held by first heater 81 (see Fig. 13).

Further, in the method for manufacturing the semiconductor device (JFET 100) in the present embodiment, JFET 100 is manufactured using silicon carbide substrate 1 thus obtained. Here, by forming active layer 8 and the like on SiC layers 20 of silicon carbide substrate 1 shown in Fig. 17, a plurality of JFETs 100 arranged side by side when viewed in a planar view are fabricated. On this occasion, each JFET 100 is fabricated so as not to extend across a boundary region between adjacent SiC layers 20.

### (Fifth Embodiment)

The following describes yet another embodiment of the present invention, i.e., a fifth embodiment. A JFET 100 (semiconductor device) in the fifth embodiment has basically the same structure and provides basically the same effects as those of JFET 100 in the first embodiment. However, JFET 100 in the fifth embodiment is different from that of the first embodiment in terms of structure of silicon carbide substrate 1.

Namely, referring to Fig. 18, in silicon carbide substrate 1 in the fifth embodiment, an amorphous SiC layer 40 is disposed between base layer 10 and SiC layer 20 as an intermediate layer made of amorphous SiC. Then, base layer 10 and SiC layer 20 are connected to each other by this amorphous SiC layer 40. Amorphous SiC layer 40 thus existing facilitates fabrication of silicon carbide substrate 1 in which base layer 10 and SiC layer 20 are stacked on each other.

The following describes a method for manufacturing silicon carbide substrate 1 in the fifth embodiment. Referring to Fig. 19, in the method for manufacturing silicon carbide substrate 1 in the fifth embodiment, the substrate preparing step is performed as step (S10) in the same way as in the first embodiment, so as to prepare base substrate 10 and SiC substrate 20.

Next, a Si layer forming step is performed as a step (S11). In this step (S11), a Si layer having a thickness of 100 nm is formed on one main surface of base substrate 10 prepared in step (S10), for example. This Si layer can be formed using the sputtering method, for example.

Next, a stacking step is performed as step (S30). In this step (S30), SiC substrate 20 prepared in step (S10) is placed on the Si layer formed in step (S11). In this way, a stacked substrate is obtained in which SiC substrate 20 is provided over base substrate 10 with the Si layer interposed therebetween.

Next, as a step (S70), a heating step is performed. In this step (S70), the stacked substrate fabricated in step (S30) is heated, for example, in a mixed gas atmosphere of hydrogen gas and propane gas under a pressure of 1 × 10³ Pa at approximately 1500°C for 3 hours. Accordingly, the Si layer is supplied with carbon as a result of diffusion mainly from base substrate 10 and SiC substrate 20, thereby forming amorphous SiC layer 40 as shown in Fig. 18. Accordingly, silicon carbide substrate 1 of the fifth embodiment can be readily manufactured in which base layer 10 and SiC layer 20 are connected to each other by amorphous SiC layer 40.

### (Sixth Embodiment)

The following describes yet another embodiment of the present invention, i.e., a sixth embodiment. A JFET 100 (semiconductor device) in the sixth embodiment has basically the same structure and provides basically the same effects as those of JFET 100 in the first embodiment. However, JFET 100 in the sixth embodiment is different from that of the first embodiment in terms of structure of silicon carbide substrate 1.

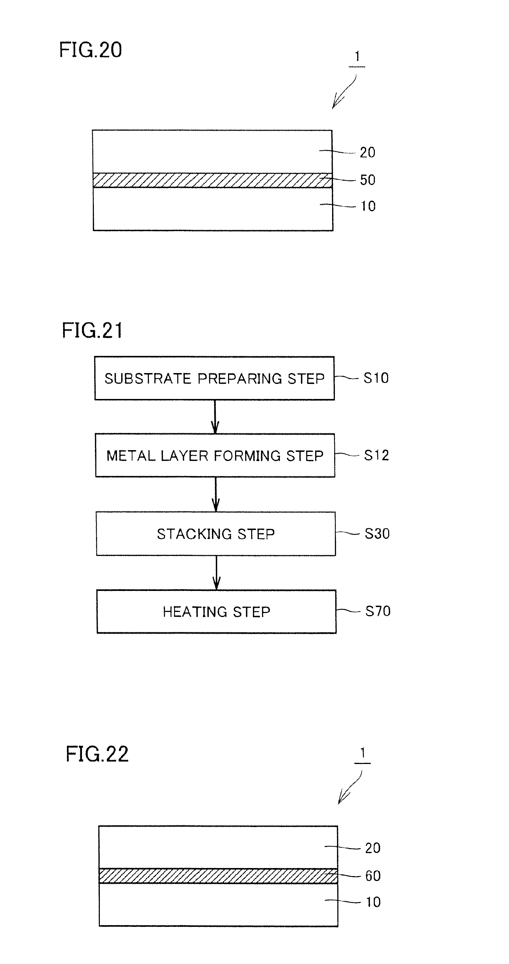

Namely, referring to Fig. 20, silicon carbide substrate 1 in the sixth embodiment is different from that of the first embodiment in that a metal layer 50 is formed between base layer 10 and SiC layer 20 as an intermediate layer. Further, base layer 10 and SiC layer 20 are connected to each other by this metal layer 50. Metal layer 50 thus existing facilitates fabrication of silicon carbide substrate 1 in which base layer 10 and SiC layer 20 are stacked on each other.

The following describes a method for manufacturing silicon carbide substrate 1 in the sixth embodiment. Referring to Fig. 21, in the method for manufacturing silicon carbide substrate 1 in the sixth embodiment, the substrate preparing step is performed as step (S10) in the same way as in the first embodiment, so as to prepare base substrate 10 and SiC substrate 20.

Next, a metal layer forming step is performed as a step (S12). In this step (S12), the metal layer is formed by, for example, depositing the metal on one main surface of base substrate 10 prepared in step (S10). This metal layer can contain, for example, at least one or more of nickel, molybdenum, titanium, and tungsten.

Next, the stacking step is performed as step (S30). In this step (S30), SiC substrate 20 prepared in step (S10) is placed on the metal layer formed in step (S12). In this way, a stacked substrate is obtained in which SiC substrate 20 is provided over base substrate 10 with the metal layer interposed therebetween.

Next, as step (S70), the heating step is performed. In this step (S70), the stacked substrate fabricated in step (S30) is heated to approximately 1000°C in an inert gas atmosphere such as argon, for example. Accordingly, silicon carbide substrate 1 of the sixth embodiment can be readily manufactured in which base layer 10 and SiC layer 20 are connected to each other by metal layer 50.

### (Seventh Embodiment)

The following describes yet another embodiment of the present invention, i.e., a seventh embodiment. A JFET 100 (semiconductor device) in the seventh embodiment has basically the same structure and provides basically the same effects as those of JFET 100 in the first embodiment. However, JFET 100 in the seventh embodiment is different from that of the first embodiment in terms of structure of silicon carbide substrate 1.

Specifically, referring to Fig. 22, silicon carbide substrate 1 of the seventh embodiment is different from that of the first embodiment in that a carbon layer 60 is formed between base layer 10 and SiC layer 20 as an intermediate layer. Then, base layer 10 and SiC layer 20 are connected to each other by this carbon layer 60. Carbon layer 60 thus existing facilitates fabrication of silicon carbide substrate 1 in which base layer 10 and SiC layer 20 are stacked on each other.

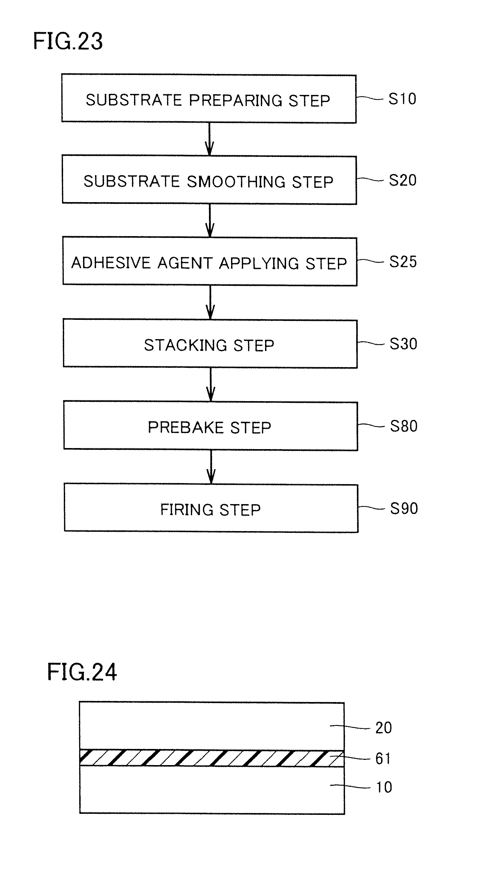

The following describes a method for manufacturing silicon carbide substrate 1 in the seventh embodiment. Referring to Fig. 23, first, step (S10) is performed in the same way as in the first embodiment, and then step (S20) is performed as required in the same way as in the first embodiment.

Next, as a step (S25), an adhesive agent applying step is performed. In this step (S25), referring to Fig. 24, for example, a carbon adhesive agent is applied to the main surface of base substrate 10, thereby forming a precursor layer 61. The carbon adhesive agent can be formed of, for example, a resin, graphite particles, and a solvent. Here, an exemplary resin usable is a resin formed into non-graphitizable carbon by heating, such as a phenol resin. An exemplary solvent usable is phenol, formaldehyde, ethanol, or the like. Further, the carbon adhesive agent is preferably applied at an amount of not less than 10 mg/cm² and not more than 40 mg/cm², more preferably, at an amount of not less than 20 mg/cm² and not more than 30 mg/cm². Further, the carbon adhesive agent applied preferably has a thickness of not more than 100 µm, more preferably, not more than 50 µm.

Next, the stacking step is performed as step (S30). In this step (S30), referring to Fig. 24, SiC substrate 20 is placed on and in contact with precursor film 61 formed on and in contact with the main surface of base substrate 10, thereby fabricating a stacked substrate.

Next, as a step (S80), a prebake step is performed. In this step (S80), the stacked substrate is heated, thereby removing the solvent component from the carbon adhesive agent constituting precursor layer 61. Specifically, for example, while applying a load to the stacked substrate in the thickness direction thereof, the stacked substrate is gradually heated to fall within a range of temperature exceeding the boiling point of the solvent component. Preferably, this heating is performed with base substrate 10 and SiC substrate 20 being pressed against each other using a clamp or the like. Further, by performing the prebaking (heating) as long as possible, the adhesive agent is degassed to improve strength in adhesion.

Next, as a step (S90), a firing step is performed. In this step (S90), the stacked substrate with precursor layer 61 heated and accordingly prebaked in step (S80) is heated to a high temperature, preferably, not less than 900°C and not more than 1100°C, for example, 1000°C for preferably not less than 10 minutes and not more than 10 hours, for example, for 1 hour, thereby firing precursor layer 61. Atmosphere employed upon the firing can be an inert gas atmosphere such as argon. The pressure of the atmosphere can be, for example, atmospheric pressure. In this way, precursor layer 61 is formed into a carbon layer 60 made of carbon. As a result, referring to Fig. 22, silicon carbide substrate 1 of the seventh embodiment is obtained in which base substrate (base layer) 10 and SiC substrate (SiC layer) 20 are connected to each other by carbon layer 60.

It should be noted that in each of the foregoing embodiments, the lateral type JFET has been illustrated as one exemplary semiconductor device of the present invention, but the semiconductor device of the present invention is not limited to this and is widely applicable to lateral type semiconductor devices. Specifically, the semiconductor device of the present invention may be, for example, a MOSFET (Metal Oxide Semiconductor Field Effect Transistor), a MESFET (Metal Semiconductor Field Effect Transistor), an IGBT (Insulated Gate Bipolar Transistor), or the like.

Further, in silicon carbide substrate 1, the crystal structure of silicon carbide constituting SiC layer 20 is preferably of hexagonal system, more preferably, 4H-SiC. Further, base layer 10 and SiC layer 20 (as well as adjacent SiC layers 20 in the case where a plurality of SiC layers 20 are provided) are preferably made of silicon carbide single-crystal having the same crystal structure. In this way, by employing silicon carbide single-crystal of the same crystal structure for base layer 10 and SiC layer 20, physical properties such as a thermal expansion coefficient become the same therebetween, thereby preventing warpage of silicon carbide substrate 1, separation of base layer 10 and SiC layer 20, or separation of SiC layers 20 in the processes of manufacturing silicon carbide substrate 1 and manufacturing a semiconductor device such as JFET100 using silicon carbide substrate 1.

Further, the silicon carbide single-crystals respectively constituting SiC layer 20 and base layer 10 (as well as adjacent SiC layers 20 in the case where a plurality of SiC layers 20 are provided) preferably have c axes forming an angle of less than 1°, more preferably, less than 0.1°. Further, it is preferable that the c planes of the respective silicon carbide single-crystals thereof are not rotated from each other in the plane.

Further, base layer (base substrate) 10 of silicon carbide substrate 1 used to manufacture the semiconductor device such as JFET 100 preferably has a diameter of 2 inches or greater, more preferably, 6 inches or greater. Furthermore, silicon carbide substrate 1 preferably has a thickness of not less than 200 µm and not more than 1000 µm, more preferably, not less than 300 µm and not more than 700 µm.

The embodiments disclosed herein are illustrative and non-restrictive in any respect. The scope of the present invention is defined by the terms of the claims, rather than the embodiments described above, and is intended to include any modifications within the scope and meaning equivalent to the terms of the claims.

### INDUSTRIAL APPLICABILITY

A semiconductor device of the present invention is advantageously applicable to a semiconductor device required to allow for reduced manufacturing cost.

### REFERENCE SIGNS LIST

1: silicon carbide substrate; 2: first p type layer; 3: n type layer; 4: second p type layer; 4A: upper surface; 5: first n type region; 6: second n type region; 7: p type region; 8: active layer; 10: base layer (base substrate); 10A: main surface; 10B: single crystal layer; 11: material substrate; 11A: main surface; 20: SiC layer (SiC substrate); 20A, 20B: main surface; 20C: end surface; 40: amorphous SiC layer; 50: metal layer; 60: carbon layer; 61: precursor layer; 81: first heater; 82: second heater; 91: oxide film; 92: source electrode; 93: drain electrode; 94: gate electrode; 95: source wire; 96: drain wire; 97: gate wire.

## Claims

1. A semiconductor device (100) comprising:
a silicon carbide substrate (1);
an active layer (8) made of single-crystal silicon carbide and disposed on one main surface of said silicon carbide substrate (1);
a first electrode (92) disposed on said active layer (8); and
a second electrode (93) formed on said active layer (8) and separated from said first electrode (92),
said silicon carbide substrate (1) including
a base layer (10) made of single-crystal silicon carbide, and
a SiC layer (20) made of single-crystal silicon carbide and disposed on said base layer (10),
said SiC layer (20) having a defect density smaller than that of said base layer (10).

2. The semiconductor device (100) according to claim 1, wherein said SiC layer (20) has a micro pipe density smaller than that of said base layer (10).

3. The semiconductor device (100) according to claim 1, wherein said SiC layer (20) has a threading screw dislocation density smaller than that of said base layer (10).

4. The semiconductor device (100) according to claim 1, wherein said SiC layer (20) has a threading edge dislocation density smaller than that of said base layer (10).

5. The semiconductor device (100) according to claim 1, wherein said SiC layer (20) has a basal plane dislocation density smaller than that of said base layer (10).

6. The semiconductor device (100) according to claim 1, wherein said SiC layer (20) has a mixed dislocation density smaller than that of said base layer (10).

7. The semiconductor device (100) according to claim 1, wherein said SiC layer (20) has a stacking fault density smaller than that of said base layer (10).

8. The semiconductor device (100) according to claim 1, wherein said SiC layer (20) has a point defect density smaller than that of said base layer (10).

9. The semiconductor device (100) according to claim 1, wherein a half width of X-ray rocking curve of said SiC layer (20) is smaller than that of said base layer (10).

10. The semiconductor device (100) according to claim 1, wherein a plurality of said SiC layers (20) are stacked.

11. The semiconductor device (100) according to claim 1, wherein said SiC layer (20) has a main surface (20A) opposite to said base layer (10) and having an off angle of not less than 85° and not more than 95° relative to a {0001} plane.

12. The semiconductor device (100) according to claim 11, wherein the main surface (20A) of said SiC layer (20) opposite to said base layer (10) corresponds to a {11-20} plane.

13. The semiconductor device (100) according to claim 11, wherein the main surface (20A) of said SiC layer (20) opposite to said base layer (10) corresponds to a {1-100} plane.

14. The semiconductor device (100) according to claim 11, wherein said first electrode (92) and said second electrode (93) are arranged in a <0001> direction of the single-crystal silicon carbide constituting said SiC layer (20).

15. The semiconductor device (100) according to claim 1, further comprising a third electrode (94) formed on said active layer (8) between said first electrode (92) and said second electrode (93) and separated from said first electrode (92) and said second electrode (93), wherein
said first electrode (92) is a source electrode,
said second electrode (93) is a drain electrode, and
said third electrode (94) is a gate electrode.

16. The semiconductor device (100) according to claim 15, wherein said active layer (8) includes:
a buffer layer (2) disposed on said silicon carbide substrate (1) and having a first conductivity type, and
a channel layer (3) disposed on said buffer layer (2) and having a second conductivity type.

17. The semiconductor device (100) according to claim 16, wherein said active layer (8) further includes:
a source region (5) having the second conductivity type and extending from its location in contact with said first electrode (92) to come into said channel layer (3),
a drain region (6) having the second conductivity type and extending from its location in contact with said second electrode (93) to come into said channel layer (3), and
a gate region (7) having the first conductivity type and extending from its location in contact with said third electrode (94) to come into said channel layer (3).

18. The semiconductor device (100) according to claim 17, wherein said active layer (8) further includes a resurf layer (4) having the first conductivity type and disposed on said channel layer (3).

19. The semiconductor device (100) according to claim 1, wherein:
said silicon carbide substrate (1) further includes an intermediate layer (40, 50, 60) disposed between said base layer (10) and said SiC layer (20), and
said intermediate layer (40, 50, 60) connects said base layer (10) and said SiC layer (20) to each other.

20. The semiconductor device (100) according to claim 19, wherein said intermediate layer (50) is made of a metal.

21. The semiconductor device (100) according to claim 19, wherein said intermediate layer (60) is made of carbon.

22. The semiconductor device (100) according to claim 19, wherein said intermediate layer (40) is made of amorphous silicon carbide.
